(19) **Europäisches Patentamt / European Patent Office / Office européen des brevets**

(11) **EP 2 078 740 A1**

(12) **EUROPEAN PATENT APPLICATION**
published in accordance with Art. 153(4) EPC

(43) Date of publication:
**15.07.2009 Bulletin 2009/29**

(51) Int Cl.:
*C09J 7/02* [(2006.01)]     *C09J 11/08* [(2006.01)]
*C09J 201/00* [(2006.01)]

(21) Application number: **07830045.6**

(22) Date of filing: **18.10.2007**

(86) International application number:
**PCT/JP2007/070311**

(87) International publication number:
**WO 2008/053713 (08.05.2008 Gazette 2008/19)**

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **04.11.2006 JP 2006299738**

(71) Applicant: **NITTO DENKO CORPORATION Ibaraki-shi Osaka 567-8680 (JP)**

(72) Inventor: **KIUCHI, Kazuyuki Ibaraki-shi Osaka 567-8680 (JP)**

(74) Representative: **Grünecker, Kinkeldey, Stockmair & Schwanhäusser Anwaltssozietät Leopoldstrasse 4 80802 München (DE)**

(54) **HEAT-PEELABLE PRESSURE-SENSITIVE ADHESIVE SHEET AND METHOD OF RECOVERING ADHEREND**

(57)  To provide a heat-peelable pressure-sensitive adhesive sheet which, even when applied to a flexible adherend or extremely small adherend, enables the adherend to be efficiently peeled and recovered therefrom without breakage.

The heat-peelable pressure-sensitive adhesive sheet includes a substrate, and arranged on one side thereof in the following order, an intermediate layer having a thickness "A", and a heat-peelable pressure-sensitive adhesive layer having a thickness "B" and containing heat-expandable microspheres with a largest particle diameter "C". The parameters A, B, and C satisfy the following conditions: $C \leq (A+B) \leq 60$ ($\mu$m) and $0.25C \leq B \leq 0.8C$, and the heat-peelable pressure-sensitive adhesive layer, when subjected to a heating treatment, shows an adhesive strength of less than 0.1 N/20 mm after the heating treatment. The heat-peelable pressure-sensitive adhesive layer after the heating treatment preferably has an arithmetic mean surface roughness Ra of 5 $\mu$m or smaller and a maximum height of the profile Rmax of 25 $\mu$m or smaller. The substrate preferably has a glass transition temperature (Tg) of 60°C or higher and a thickness of 50 $\mu$m or smaller.

EP 2 078 740 A1

## Description

Technical Field

The present invention relates to a heat-peelable pressure-sensitive adhesive sheet and a method of recovering an adherend using the same. More specifically, it relates to a method of more quickly and more easily peeling and recovering adherends through a heating treatment. It also relates to a method of efficiently peeling and recovering semiconductor components and electronic components using the peeling/recovering method.

Background Art

Recently, semiconductor components and electronic components have been more and more small-sized and slimmed, and thereby become difficult to handle. Additionally, improvements in productivity of these components are important problems to be solved. Particularly, to seek means for peeling and recovering a component, which is small and fragile and is temporarily fixed to pressure-sensitive adhesive sheets, from the pressure-sensitive adhesive sheets without breakage is an important issue. It is effective for small-sized and slimmed components to handle them with heat-peelable pressure-sensitive adhesive sheets that are spontaneously peelable.

There have been known heat-peelable pressure-sensitive adhesive sheets each including a substrate and,' arranged thereon, a pressure-sensitive adhesive layer containing a blowing agent or expanding agent such as heat-expandable microspheres (see Patent Documents 1 to 6). The heat-peelable pressure-sensitive adhesive sheets are pressure-sensitive adhesive sheets having both satisfactory adhesion and satisfactory peelability after use. When they are heated, the blowing agent or another component therein is allowed to expand or foam to reduce their bond strength, whereby they can be easily peeled off from adherends such as silicon wafers. Among them, heat-peelable pressure-sensitive adhesive sheets using heat-expandable microspheres have been widely used typically as devices for temporal fixation during manufacture processes of semiconductor or electronic components, because the heat-expandable microspheres expand through heating to significantly reduce the contact area between the pressure-sensitive adhesive layer and the adherend, and this allows the adherend to be recovered without breakage. However, the productivity is significantly impaired when the adherend is a recent highly flexible semiconductor chip, called "ultrathin chip", with a thickness of 40 $\mu$m or smaller or an extremely small component. This is because such flexible or extremely small adherend is likely to follow the surface roughness, caused through a heat treatment, of the heat-peelable pressure-sensitive adhesive sheet; this impedes sufficient reduction in contact area between the pressure-sensitive adhesive layer and the adherend; and it may take much time to peel the adherend or it may be difficult to peel the adherend from the pressure-sensitive adhesive sheet.

[Patent Document 1] Japanese Examined Patent Application Publication (JP-B) No. S51-24534
[Patent Document 2] Japanese Unexamined Patent Application Publication (JP-A) No. S56-61468
[Patent Document 3] JP-A No. S56-61469
[Patent Document 4] JP-A No. S60-252681
[Patent Document 5] JP-A No. 2001-131507
[Patent Document 6] JP-A No. 2002-146299

Disclosure of Invention

Problems to be Solved by the Invention

Accordingly, an object of the present invention is to provide a heat-peelable pressure-sensitive adhesive sheet which, even when applied to a flexible adherend typically with a thickness of 40 $\mu$m or smaller or extremely small adherend, enables the adherend to be efficiently peeled and recovered therefrom without breakage; and to provide a method of recovering an adherend using the same.

Means for Solving the Problems

After intensive investigations to achieve the objects, the present inventors have found that a heat-peelable pressure-sensitive adhesive sheet including a substrate, an intermediate layer, and a heat-peelable pressure-sensitive adhesive layer, even when applied to a flexible adherend or extremely small adherend, enables the adherend to be efficiently peeled and recovered therefrom, when a specific relationship exists among the thickness of the intermediate layer, the thickness of the heat-peelable pressure-sensitive adhesive layer, and the largest particle diameter of heat-expandable microspheres contained in the heat-peelable pressure-sensitive adhesive layer. The present invention has been made based on these findings.

Specifically, the present invention provides a heat-peelable pressure-sensitive adhesive sheet which includes a substrate, and arranged on one side thereof in the following order, an intermediate layer having a thickness "A", and a heat-peelable pressure-sensitive adhesive layer having a thickness "B" and containing heat-expandable microspheres with a largest particle diameter "C". In the adhesive sheet, the parameters A, B, and C satisfy the following conditions: $C \leq (A+B) \leq 60$ ($\mu$m) and $0.25C \leq B \leq 0.8C$, and the heat-peelable pressure-sensitive adhesive layer, when subjected to a heating treatment, shows an adhesive strength of less than 0.1 N/20 mm after the heating treatment.

In the heat-peelable pressure-sensitive adhesive sheet, the heat-peelable pressure-sensitive adhesive layer after the heating treatment preferably has an arithmetic mean surface roughness Ra of 5 $\mu$m or smaller and a maximum height of the profile Rmax of 25 $\mu$m or smaller. Preferably, the substrate has a glass transition temperature (Tg) of 60°C or higher and a thickness of 50 $\mu$m or smaller.

The heat-peelable pressure-sensitive adhesive sheet may further include a long separator and be wound as a roll, in which the substrate, the intermediate layer, and the heat-peelable pressure-sensitive adhesive layer are cut into pieces of a given shape, and the pieces are arrayed on the separator so that the heat-peelable pressure-sensitive adhesive layer is in contact with the separator.

The present invention further provides a method of recovering an adherend, in which the adherend is placed on the heat-peelable pressure-sensitive adhesive layer of the heat-peelable pressure-sensitive adhesive sheet. The method includes the steps of applying heat to the heat-peelable pressure-sensitive adhesive layer via the substrate of the sheet or via the adherend to allow the heat-expandable microspheres in the heat-peelable pressure-sensitive adhesive layer to expand; and subsequently peeling and recovering the adherend from the sheet.

The adherend can be a semiconductor component or electronic component.

As used herein, the term "pressure-sensitive adhesive sheet" further includes a pressure-sensitive adhesive tape. Advantages

According to the present invention, an adherend, even when being a flexible ultrathin adherend typically with a thickness of 40 $\mu$m or smaller or an extremely small adherend, can be efficiently peeled and recovered from the pressure-sensitive adhesive sheet without breakage. In particular, even fragile semiconductor chips not to be recovered by a known needle pick-up process (a process of raising semiconductor chips with a needle) can be highly efficiently peeled and recovered from the pressure-sensitive adhesive sheet.

Brief Description of Drawings

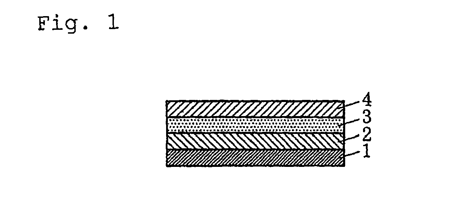

[Fig. 1] Fig. 1 is a schematic cross-sectional view showing a heat-peelable pressure-sensitive adhesive sheet according to an embodiment of the present invention.

Reference Numerals

1 substrate
2 intermediate layer
3 heat-peelable pressure-sensitive adhesive layer
4 separator

Best Modes for Carrying Out the Invention

The present invention will be illustrated in detail below with reference to the attached drawing according to necessity. Fig. 1 is a schematic cross-sectional view showing a heat-peelable pressure-sensitive adhesive sheet according to an embodiment of the present invention.

The heat-peelable pressure-sensitive adhesive sheet according to the embodiment as in Fig. 1 includes a substrate 1, and arranged on one side thereof in the following order, an intermediate layer 2, a heat-peelable pressure-sensitive adhesive layer 3, and a separator 4.

The substrate 1 acts as a base material (supporting base) typically for the heat-peelable pressure-sensitive adhesive layer 3. The substrate 1 is generally a plastic film or sheet but can be any suitable thin article. Exemplary thin articles include papers, fabrics, nonwoven fabrics, and metal foils; laminates of these with plastics; and laminates of plural plies of plastic films (or sheets). The thickness of substrate 1 is generally from about 500 $\mu$m or smaller, preferably from about 1 to about 300 $\mu$m, and more preferably from about 5 to about 250 $\mu$m, but not limited thereto.

For peeling and recovering an adherend with good productivity, it is desired to transfer heat from a heat source to the heat-peelable pressure-sensitive adhesive layer 3 efficiently so as to allow the heat-peelable pressure-sensitive adhesive layer 3 to have a temperature equal to or higher than the thermal expansion starting temperature of the heat-expandable microspheres. Accordingly, the substrate 1 is preferably one which can immediately transfer heat to the heat-peelable pressure-sensitive adhesive layer 3 and is highly thermally stable. As a substrate of this type, preferred is a substrate having a glass transition temperature (Tg) of 60°C or higher and a thickness of 50 $\mu$m or smaller (for example, from about 5 to about 50 $\mu$m). Exemplary preferred substrates include films of polyesters such as poly(ethylene terephthalate)s, poly(ethylene naphthalate)s, and poly(butylene terephthalates; films of plastics such as polyimides and polyamides; foils of metals such as copper, nickel, and SUS (stainless steel); plastic films containing metal powders dispersed therein; and anisotropically conductive films. The substrate 1 may be a single-layer film or multilayer film of these materials.

The intermediate layer 2 is capable of absorbing or smoothing the surface unevenness of the heat-peelable pressure-sensitive adhesive layer 3 caused by the heat-expandable microspheres contained therein and thereby helps to keep the surface of the heat-peelable pressure-sensitive adhesive layer 3 before heating being smooth. It is also capable of relaxing the stress on the substrate 1 caused by blowing heat-expandable microspheres after heating and thereby helps to prevent the anchor failure with respect to the substrate 1. The intermediate layer 2 is therefore preferably elastic. Exemplary usable materials for the intermediate layer 2 include natural or synthetic resins such as natural or synthetic rubber resins and thermoplastic or thermosetting elastomers; pressure-sensitive adhesives such as rubber, acrylic, vinyl alkyl ether, silicone, and urethane pressure-sensitive adhesives; and energy-ray curable resins or pressure-sensitive adhesives that cure by the action of energy rays such as ultraviolet rays. The intermediate layer 2 may further contain, in addition to these materials, suitable modifiers such as resins, crosslinking agents, plasticizers, surfactants, and fillers. The intermediate layer 2 may also further contain, for example, metal powders to improve its thermal conductivity. Generally, the intermediate layer 2 often contains a material identical or similar to the adhesive material used in the heat-peelable pressure-sensitive adhesive layer 3.

The intermediate layer 2 may have a single-layer or multilayer structure. The thickness of the intermediate layer 2 is generally from about 1 to about 50 $\mu$m, preferably from about 3 to about 40 $\mu$m, more preferably from about 5 to about 30 $\mu$m, and particularly preferably from about 10 to about 25 $\mu$m.

The way to form the intermediate layer 2 is not particularly limited and can be any common technique such as a process of applying, directly to the substrate 1, a solution or dispersion containing materials for constituting the intermediate layer, and drying the applied film; a process of applying, to a suitable separator, a solution or dispersion containing materials for constituting the intermediate layer, drying the applied film, and transferring the dried film onto the substrate 1; as well as dry lamination; extrusion; and coextrusion.

The heat-peelable pressure-sensitive adhesive layer 3 contains a pressure-sensitive adhesive (adhesive material) for imparting tackiness, and heat-expandable microspheres for imparting peelability through heating (heat peelability). Therefore, after the sheet is applied to an adherend, the adherend can be peeled off therefrom at any time by carrying out a heating treatment to allow the heat-expandable microspheres to expand to thereby reduce the contact area between the adhesive layer 3 and the adherend. The heat-expandable microspheres are preferably microcapsulated.

The pressure-sensitive adhesive is preferably one that does not impede the expansion of the heat-expandable microspheres during heating. Examples of such pressure-sensitive adhesives include rubber pressure-sensitive adhesives, acrylic pressure-sensitive adhesives, vinyl alkyl ether pressure-sensitive adhesives, silicone pressure-sensitive adhesives, urethane pressure-sensitive adhesives, and energy-ray-curable pressure-sensitive adhesives. Each of different pressure-sensitive adhesives can be used alone or in combination. Such pressure-sensitive adhesives may further contain, in addition to the tacky component (base polymer), suitable additives. Exemplary additives include crosslinking agents such as polyisocyanates and alkyl-etherified melamine compounds; tackifiers such as rosin derivative resins, polyterpene resins, petroleum resins, and oil-soluble phenol resins; plasticizers; fillers; and age inhibitors. In particular, a heat-peelable pressure-sensitive adhesive layer, when containing a low-molecular-weight component such as a plasticizer, may have a satisfactorily low adhesive strength after heating and thereby exhibit good peelability.

Exemplary materials generally used as the pressure-sensitive adhesive include rubber pressure-sensitive adhesives containing natural rubbers and various synthetic rubbers as base polymers; and acrylic pressure-sensitive adhesives containing, as base polymers, acrylic polymers (homopolymers or copolymers) using, as monomer components, one or more of alkyl esters of (meth)acrylic acids. Exemplary alkyl esters include ($C_1$-$C_{20}$) alkyl esters such as methyl ester, ethyl ester, propyl ester, isopropyl ester, butyl ester, 2-ethylhexyl ester, isooctyl ester, isononyl ester, isodecyl ester, dodecyl ester, tridecyl ester, pentadecyl ester, hexadecyl ester, heptadecyl ester, octadecyl ester, nonadecyl ester, and eicosyl ester.

Where necessary, the acrylic polymer may further contain units corresponding to one or more other monomer components that are copolymerizable with the (meth)acrylic acid alkyl ester(s), so as to improve or modify properties such as cohesive strength, thermal stability, and crosslinkability. Exemplary copolymerizable monomer components include carboxyl-containing monomers such as acrylic acid, methacrylic acid, and itaconic acid; acid anhydride monomers such as maleic anhydride; hydroxyl-containing monomers such as hydroxyethyl (meth)acrylates and hydroxypropyl (meth)acrylates; sulfonic-containing monomers such as styrenesulfonic acid and allylsulfonic acid; amido-containing monomers such as N-methylol(meth)acrylamides; aminoalkyl (meth)acrylate monomers such as aminoethyl (meth) acrylates; alkoxyalkyl (meth)acrylate monomers such as methoxyethyl (meth)acrylates; maleimide monomers such as N-cyclohexylmaleimide; itaconimide monomers such as N-methylitaconimide; succinimide monomers such as N-(meth) acryloyloxymethylenesuccinimide; vinyl monomers such as vinyl acetate, vinyl propionate, vinylpyridine, and styrene; cyano acrylate monomers such as acrylonitrile and methacrylonitrile; epoxy-containing acrylic monomers such as glycidyl (meth)acrylates; glycolic acrylic ester monomers such as polyethylene glycol (meth)acrylates; acrylic ester monomers having, for example, a heterocycle, halogen atom, or silicon atom, such as tetrahydrofurfuryl (meth)acrylates, fluorine-containing (meth)acrylates, and silicone (meth)acrylates; multifunctional monomers such as hexanediol di(meth)acrylates, neopentyl glycol di(meth)acrylates, pentaerythritol di(meth)acrylates, trimethylolpropane tri(meth)acrylates, polyester acrylates, and urethane acrylates; olefinic monomers such as isoprene, butadiene, and isobutylene; and vinyl ether monomers such as vinyl ether. Each of different monomer components can be used alone or in combination.

The heat-expandable microspheres are preferably those composed of an elastic shell and, encapsulated therein, a low-boiling material such as isobutane, propane, or pentane. The shell is often composed of a thermally fusible material or a material that breaks as a result of thermal expansion. Exemplary materials for constituting the shell include vinylidene chloride-acrylonitrile copolymers, poly(vinyl alcohol)s, poly(vinyl butyral)s, poly(methyl methacrylate)s, polyacrylonitriles, poly(vinylidene chloride)s, and polysulfones. The heat-expandable microspheres can be prepared according to a common procedure such as coacervation process or interfacial polymerization. Such heat-expandable microspheres are also commercially available typically as Microsphere [trade name; from Matsumoto Yushi-Seiyaku Co., Ltd.].

The amount of heat-expandable microspheres is generally from 1 to 100 parts by weight, preferably from 5 to 75 parts by weight, and more preferably from 15 to 50 parts by weight, per 100 parts by weight of pressure-sensitive adhesives, while varying depending on the particle diameter and coefficient of thermal expansion of the heat-expandable microspheres.

The thickness of the heat-peelable pressure-sensitive adhesive layer 3 is generally from about 5 to about 59 $\mu$m, preferably from about 10 to about 45 $\mu$m, more preferably from about 15 to about 40 $\mu$m, and particularly preferably from about 20 to about 35 $\mu$m. A heat-peelable pressure-sensitive adhesive layer 3, if having an excessively large thickness, may cause cohesive failure upon peeling after heating treatment, and this may often cause the pressure-sensitive adhesive to remain on the adherend to thereby contaminate or stain the adherend. On the other hand, a heat-expandable pressure-sensitive adhesive layer 3, if having an excessively small thickness, may not deform sufficiently during the heating treatment and may not have a smoothly decreased bond strength. Alternatively, heat-expandable microspheres to be contained therein should have excessively small particle diameters.

The way to form the heat-peelable pressure-sensitive adhesive layer 3 can be any process such as a process of preparing a coating composition containing pressure-sensitive adhesives and heat-expandable microspheres where necessary with a solvent, and applying the coating composition directly to the intermediate layer 2; or a process of applying the coating composition to a suitable separator (such as release paper) to form a heat-peelable pressure-sensitive adhesive layer, and transferring this onto the intermediate layer 2. The latter transferring process is more preferred from the viewpoint of the smoothness of the heat-peelable pressure-sensitive adhesive layer 3 before heating.

The separator 4 can be, for example, a common release paper. The separator 4 is used as a protector for the heat-peelable pressure-sensitive adhesive layer 3 and is removed when the pressure-sensitive adhesive sheet is applied to an adherend. It is not always necessary to provide a separator 4.

A heat-peelable pressure-sensitive adhesive sheet of the present invention may further include a long (generally wide) separator and is wound as a roll, in which the substrate, the intermediate layer, and the heat-peelable pressure-sensitive adhesive layer have been cut into pieces of a given shape, and the pieces are arrayed on the separator so that the heat-peelable pressure-sensitive adhesive layer is in contact with the separator.

The heat-peelable pressure-sensitive adhesive layer 3 may be arranged on one side of the substrate 1 or on both sides thereof. When the heat-peelable pressure-sensitive adhesive layer 3 is arranged on both sides of the substrate 1, the intermediate layer 2 may be arranged on one or both sides of the substrate 1 between the substrate 1 and the heat-peelable pressure-sensitive adhesive layer 3. According to another embodiment, a heat-peelable pressure-sensitive adhesive sheet may include a substrate 1; a heat-peelable pressure-sensitive adhesive layer 3 arranged on one side of the substrate 1; and a regular adhesive layer containing no heat-expandable microsphere and arranged on the other side of the substrate 1. A thin layer such as an undercoat layer and an adhesive layer may be provided between the substrate and the intermediate layer 2 and/or between the intermediate layer 2 and the heat-peelable pressure-sensitive adhesive layer 3.

An important feature of the present invention is that, in a heat-peelable pressure-sensitive adhesive sheet which includes a substrate, and arranged on one side thereof in the following order, an intermediate layer having a thickness "A" ($\mu$m); and a heat-peelable pressure-sensitive adhesive layer having a thickness "B" ($\mu$m) and containing heat-expandable microspheres with a largest particle diameter "C" ($\mu$m), the parameters A, B, and C satisfy the following conditions (1) and (2), and the heat-peelable pressure-sensitive adhesive layer shows an adhesive strength of less than 0.1 N/20 mm after the heating treatment.

$$C \leq (A+B) \leq 60 \quad (\mu m) \qquad (1)$$

$$0.25C \leq B \leq 0.8C \qquad (2)$$

Heat-peelable pressure-sensitive adhesive sheets having this configuration have both satisfactory good adhesion to an adherend before heating and good peelability from the adherend after heating, even when applied to a flexible adherend (such as a silicon semiconductor chip with a thickness of about 30 $\mu$m) or an extremely small adherend. By setting the total thickness (A plus B) of the intermediate layer 2 and the heat-peelable pressure-sensitive adhesive layer 3 equal to or larger than the largest particle diameter "C" of the heat-expandable microspheres as in the condition (1), the heat-peelable pressure-sensitive adhesive layer before heating can maintain its surface smoothness and thereby ensure good adhesion to the adherend. If A plus B is smaller than C, the heat-peelable pressure-sensitive adhesive layer before heating has impaired surface smoothness, and this will cause problems such as cracking of a fragile adherend upon application to the adherend. By setting total thickness (A plus B) of the intermediate layer 2 and the heat-peelable pressure-sensitive adhesive layer 3 to be 60 $\mu$m or smaller, the heat-expandable microspheres can more quickly expand by heating, the heat-peelable pressure-sensitive adhesive layer more largely deforms after thermal expansion, and this enables more precise alignment of the adherend upon its recovery.

By setting the thickness "B" of the heat-peelable pressure-sensitive adhesive layer 3 to be from 0.25 times to 0.8 times the largest particle diameter "C" of the heat-expandable microspheres as in the condition (2), the pressure-sensitive adhesive sheet can be satisfactorily peeled off from even a flexible ultrathin adherend or extremely small adherend through heating. If B is larger than 0.8C, the heat-peelable pressure-sensitive adhesive layer shows larger surface roughness after heating, and, when applied to a flexible adherend, the adherend can follow the surface roughness (unevenness) of the pressure-sensitive adhesive layer and may not be satisfactorily peeled therefrom. On the other hand, if B is smaller than 0.25C, the contact area between the heat-peelable pressure-sensitive adhesive layer and the adherend after heating does not sufficiently decrease, and this may cause peeling failure.

If the heat-peelable pressure-sensitive adhesive layer after heating treatment shows an adhesive strength of 0.1 N/20 mm or more, the adherend is not satisfactorily peeled off therefrom and is thereby not efficiently recovered. The adhesive strength of the heat-peelable pressure-sensitive adhesive layer after heating treatment can be controlled by changing typically the thickness of the heat-peelable pressure-sensitive adhesive layer, the types and amounts of pressure-sensitive adhesives and additives (such as crosslinking agents and tackifiers) constituting the heat-peelable pressure-sensitive adhesive layer, and the type and amount of the heat-expandable microspheres.

Additionally, the heat-peelable pressure-sensitive adhesive layer after heating treatment has an arithmetic mean surface roughness Ra of preferably 5 $\mu$m or smaller, and more preferably 4.5 $\mu$m or smaller and/or a maximum height of the profile Rmax of preferably 25 $\mu$m or smaller, and more preferably 23 $\mu$m or smaller. This significantly inhibits even a flexible adherend from following the surface roughness (unevenness) of the heat-peelable pressure-sensitive adhesive layer after heating treatment. The arithmetic mean surface roughness Ra and maximum height of the profile Rmax of the heat-peelable pressure-sensitive adhesive layer after heating treatment can be controlled by suitably selecting, for example, the thickness of the heat-peelable pressure-sensitive adhesive layer and the particle diameter of the heat-expandable microspheres to be incorporated in the pressure-sensitive adhesive layer.

According to the method of recovering an adherend according to the present invention, where the adherend is placed on the heat-peelable pressure-sensitive adhesive layer of the heat-peelable pressure-sensitive adhesive sheet, heating is carried out from the substrate side (the side where no heat-peelable pressure-sensitive adhesive layer is arranged) of the sheet or from the adherend side to allow the heat-expandable microspheres in the heat-peelable pressure-sensitive adhesive layer to expand, and subsequently the adherend is peeled and recovered from the sheet. Exemplary adherends for use herein include semiconductor components such as semiconductor wafers and chips; and electronic components such as ceramic capacitors and resonators.

The heating treatment is generally conducted by bringing a heat source into contact with the side of the substrate where no pressure-sensitive adhesive layer is arranged or with the adherend. Heat transfers from the substrate or adherend to the heat-peelable pressure-sensitive adhesive layer, to allow the heat-expandable microspheres in the heat-peelable pressure-sensitive adhesive layer to expand, and this causes the pressure-sensitive adhesive layer to expand and deform, and thus the pressure-sensitive adhesive layer has a reduced bond strength or loses its bond strength. Exemplary heat sources include, but not limited to, hot plates, dryers, and infrared rays. The heating conditions can be suitably selected according to the type and area of the adherend. The heating is preferably conducted at a temperature 50°C or more higher than the starting temperature of expansion of the heat-expandable microspheres. This enables smooth peeling of the sheet from an 8-inch silicon wafer 30 $\mu$m thick within, for example, 3 seconds. The adherends arranged on the heat-peelable pressure-sensitive adhesive layer may be peeled off in one step, or each part of the adherends may be heated and peeled off one by one. The way to peel and recover the adherend is not particularly limited and can be a common procedure such as a process of using an adsorption collet.

Examples

The present invention will be illustrated in further detail with reference to several examples below. It should be noted, however, that these examples are never construed to limit the scope of the present invention.

EXAMPLE 1

An intermediate layer 25 $\mu$m thick was formed on a polyimide film substrate 25 $\mu$m thick (trade name "Kapton H100", supplied by E.I.du Pont de Nemours and Company, having a glass transition temperature Tg of 300°C or higher) by applying a toluene solution containing 100 parts by weight of an acrylic polymer A [a 50/50/4 (by weight) copolymer of 2-ethylhexyl acrylate/ethyl acrylate/2-hydroxyethyl acrylate] and 3 parts by weight of an isocyanate crosslinking agent [trade name "CORONATE L", supplied by Nippon Polyurethane Industry Co., Ltd.] to the substrate, followed by drying. Independently, a separator-carrying heat-peelable pressure-sensitive adhesive layer was prepared by applying, to a polyester film which had been treated with a silicone releasing agent, a toluene solution containing 100 parts by weight of the acrylic polymer A, 40 parts by weight of heat-expandable microspheres A [trade name "Matsumoto Microsphere F-301D", supplied by Matsumoto Yushi-Seiyaku Co., Ltd.; having an expansion starting temperature of 90°C, a median diameter of 11.5 $\mu$m, and a largest particle diameter of 42 $\mu$m], 4 parts by weight of an isocyanate crosslinking agent [trade name "CORONATE L", supplied by Nippon Polyurethane Industry Co., Ltd.], and 10 parts by weight of a plasticizer [trade name "MONOCIZER W-700", supplied by Dainippon Ink & Chemicals, Inc.], followed by drying. The separator-carrying heat-peelable pressure-sensitive adhesive layer was applied onto the intermediate layer on the substrate and thereby yielded a heat-peelable pressure-sensitive adhesive sheet A. The heat-peelable pressure-sensitive adhesive layer has a thickness of 30 $\mu$m, and the pressure-sensitive adhesive sheet has a total thickness of 80 $\mu$m.

EXAMPLE 2

A heat-peelable pressure-sensitive adhesive sheet B having a total thickness of 93 $\mu$m was prepared by the procedure of Example 1, except for using a poly(ethylene terephthalate) substrate 38 $\mu$m thick (having a glass transition temperature Tg of 68°C) instead of the polyimide substrate 25 $\mu$m thick.

COMPARATIVE EXAMPLE 1

An intermediate layer 13 $\mu$m thick was formed on a poly(ethylene terephthalate) substrate 38 $\mu$m thick by applying thereto a toluene solution containing 100 parts by weight of the acrylic polymer A as with Example 1 and 3 parts by weight of the isocyanate crosslinking agent as with Example 1, followed by drying.
Independently, a separator-carrying heat-peelable pressure-sensitive adhesive layer was prepared by applying, to a polyester film which had been treated with a silicone releasing agent, a toluene solution containing 100 parts by weight of the acrylic polymer A, 30 parts by weight of the heat-expandable microspheres A as with Example 1, 3.5 parts by weight of the isocyanate crosslinking agent as with Example 1, and 4 parts by weight of a rosin ester tackifier, followed by drying. The separator-carrying heat-peelable pressure-sensitive adhesive layer was applied onto the intermediate layer on the substrate and thereby yielded a heat-peelable pressure-sensitive adhesive sheet C. The heat-peelable pressure-sensitive adhesive layer has a thickness of 37 $\mu$m, and the pressure-sensitive adhesive sheet has a total thickness of 88 $\mu$m.

COMPARATIVE EXAMPLE 2

An intermediate layer 13 $\mu$m thick was formed on a poly(ethylene terephthalate) substrate 38 $\mu$m thick by applying thereto a toluene solution containing 100 parts by weight of the acrylic polymer A as with Example 1 and 1 part by weight of the isocyanate crosslinking agent as with Example 1, followed by drying.
Independently, a separator-carrying heat-peelable pressure-sensitive adhesive layer was prepared by applying, to a polyester film which had been treated with a silicone' releasing agent, a toluene solution containing 100 parts by weight of the acrylic polymer A, 30 parts by weight of the heat-expandable microspheres A as with Example 1, 2 parts by weight of the isocyanate crosslinking agent as with Example 1, and 20 parts by weight of a terpene-phenol tackifier, followed by drying. The separator-carrying heat-peelable pressure-sensitive adhesive layer was applied onto the intermediate layer on the substrate and thereby yielded a heat-peelable pressure-sensitive adhesive sheet D. The heat-peelable pressure-sensitive adhesive layer has a thickness of 37μm, and the pressure-sensitive adhesive sheet has a total thickness of 88 μm.

Evaluation Tests

There were measured and evaluated the adhesive strength before and after heating of the heat-peelable pressure-sensitive adhesive sheets prepared according to Examples and Comparative Examples; and the surface roughness (arithmetic mean surface roughness and maximum height of the profile) and peelability after heating of the pressure-sensitive adhesive layer of the pressure-sensitive adhesive sheets, according to the following methods. The results are shown in Table 1.

(Adhesive Strength)

A poly(ethylene terephthalate) film 30 mm wide and 25 μm thick was applied to the heat-peelable pressure-sensitive adhesive layer of a sample heat-peelable pressure-sensitive adhesive sheet 20 mm wide, and the load was measured upon peeling of the poly(ethylene terephthalate) film at a peel angle of 180 degrees and a peel rate of 300 mm/min (adhesive strength before heating). The application of the poly(ethylene terephthalate) film was conducted through one reciprocating motion of a 2-kgf rubber roller at a rate of 300 mm/min.
Independently, the pressure-sensitive adhesive sheet was heated on a hot plate at 100°C for one minute, and the adhesive strength after heating was measured in the same way as above.

(Surface Roughness)

A sample heat-peelable pressure-sensitive adhesive sheet was subjected to a heating treatment on a hot plate at 100°C for one minute; a silicone resin (trade name "#6810", supplied by Dow Corning Toray Co., Ltd.) was added dropwise onto the heat-peelable pressure-sensitive adhesive layer of the sheet, defoamed in vacuo, precured in an air forced oven at 85°C for 30 minutes, from which the heat-peelable pressure-sensitive adhesive sheet was peeled, and the silicone resin was then fully cured in an air forced oven at 150°C for 30 minutes to give a replica of the surface of heat-peelable pressure-sensitive adhesive layer after heating treatment. The surface roughness (arithmetic mean surface roughness Ra and maximum height of the profile Rmax) of the replica was measured with a surface profiler (trade name "P-11", supplied by KLA-Tencor Corporation).

(Peelability Through Heating)

Silicon chips each 1-mm square and 30 μm thick were applied to the heat-peelable pressure-sensitive adhesive layer of a sample heat-peelable pressure-sensitive adhesive sheet; heating was conducted from the substrate side with a microheater (at temperatures of 180°C and 300°C) of the same size with each silicon chip to allow the heat-peelable pressure-sensitive adhesive layer to expand; silicon chip were picked up with an adsorption collet; and the percentage of success of picking up was determined.
[Table 1]

TABLE 1

|  | Example 1 | Example 2 | Com. Ex. 1 | Com. Ex. 2 |
|---|---|---|---|---|
| Thickness A(μm) of intermediate layer | 25 | 25 | 13 | 13 |
| Thickness B(μm) of heat-peelable pressure-sensitive adhesive layer | 30 | 30 | 37 | 37 |
| Largest particle diameter C(μm) of heat-expandable microspheres | 42 | 42 | 42 | 42 |
| A+B | 55 | 55 | 50 | 50 |
| B/C | 0.71 | 0.71 | 0.88 | 0.88 |

(continued)

|  | | | Example 1 | Example 2 | Com. Ex. 1 | Com. Ex. 2 |
|---|---|---|---|---|---|---|
| Adhesive strength (N/20 mm) | Before heating | | 1.05 | 1.05 | 2.5 | 4.8 |
| | After heating | | 0.00 | 0.00 | 0.01 | 0.02 |
| Surface roughness ($\mu$m) | Ra | | 4.25 | 4.25 | 5.87 | 5.01 |
| | Rmax | | 22.07 | 22.07 | 27.76 | 31.40 |
| Peelability through heating | 180°C | Heating duration (ms) | 141 | 220 | 220 | 220 |
| | | Percentage of success of picking up (%) | 100 | 100 | 75 | 45 |
| | 300°C | Heating duration (ms) | 85 | - | - | - |
| | | Percentage of success of picking up (%) | 100 | - | - | - |

(Evaluation Results)

With reference to Table 1, the heat-peelable pressure-sensitive adhesive sheets according to Examples 1 and 2 and corresponding to the present invention show good peelability through heating; in contrast, the heat-peelable pressure-sensitive adhesive sheets according to Comparative Examples 1 and 2, in which the thickness "B" of the heat-peelable pressure-sensitive adhesive layer is larger than 0.8C, where C is the largest particle diameter of the heat-expandable microspheres, show low percentages of success of picking up chips. In particular, the heat-peelable pressure-sensitive adhesive sheet according to Example 1 uses a polyimide substrate and can thereby be heated at 300°C, and this enables picking up of chips at extremely high speed. Industrial Applicability

Small-sized and slimmed semiconductor components and electronic components, particularly small and fragile components temporarily fixed to pressure-sensitive adhesive sheets, can be efficiently recovered without breakage through peeling. This can be applied to the manufacture of small-sized and slimmed semiconductor components and electronic components that are difficult to handle.

**Claims**

1. A heat-peelable pressure-sensitive adhesive sheet comprising a substrate, and arranged on one side thereof in the following order, an intermediate layer having a thickness "A", and a heat-peelable pressure-sensitive adhesive layer having a thickness "B" and containing heat-expandable microspheres with a largest particle diameter "C", wherein the parameters A, B, and C satisfy the following conditions: C≤(A+B)≤60 ($\mu$m) and 0.25C≤B≤0.8C, and wherein the heat-peelable pressure-sensitive adhesive layer, when subjected to a heating treatment, shows an adhesive strength of less than 0.1 N/20 mm after the heating treatment.

2. The heat-peelable pressure-sensitive adhesive sheet of claim 1, wherein the heat-peelable pressure-sensitive adhesive layer after the heating treatment has an arithmetic mean surface roughness Ra of 5 $\mu$m or smaller.

3. The heat-peelable pressure-sensitive adhesive sheet of claim 1, wherein the heat-peelable pressure-sensitive adhesive layer after the heating treatment has a maximum height of the profile Rmax of 25 $\mu$m or smaller.

4. The heat-peelable pressure-sensitive adhesive sheet of claim 1, wherein the substrate has a glass transition temperature (Tg) of 60°C or higher and a thickness of 50 $\mu$m or smaller.

5. The heat-peelable pressure-sensitive adhesive sheet of any one of claims 1 to 4, further comprising a continuous separator and being wound as a roll, wherein the substrate, the intermediate layer, and the heat-peelable pressure-sensitive adhesive layer are cut into pieces of a given shape, and the pieces are arrayed on the separator so that the heat-peelable pressure-sensitive adhesive layer is in contact with the separator.

6. A method of recovering an adherend, the adherend being placed on the heat-peelable pressure-sensitive adhesive layer of the heat-peelable pressure-sensitive adhesive sheet of any one of claims 1 to 4, the method comprising the steps of applying heat to the heat-peelable pressure-sensitive adhesive layer via the substrate of the sheet or via the adherend to allow the heat-expandable microspheres in the heat-peelable pressure-sensitive adhesive layer to expand; and subsequently peeling and recovering the adherend from the sheet.

7. The method of recovering an adherend, according to claim 6, wherein the adherend is a semiconductor component or an electronic component.

Fig. 1

# EP 2 078 740 A1

| INTERNATIONAL SEARCH REPORT | International application No. |
|---|---|
| | PCT/JP2007/070311 |

**A. CLASSIFICATION OF SUBJECT MATTER**
*C09J7/02*(2006.01)i, *C09J11/08*(2006.01)i, *C09J201/00*(2006.01)i

According to International Patent Classification (IPC) or to both national classification and IPC

**B. FIELDS SEARCHED**

Minimum documentation searched (classification system followed by classification symbols)
C09J7/02, C09J11/08, C09J201/00

Documentation searched other than minimum documentation to the extent that such documents are included in the fields searched
Jitsuyo Shinan Koho          1922-1996   Jitsuyo Shinan Toroku Koho   1996-2007
Kokai Jitsuyo Shinan Koho    1971-2007   Toroku Jitsuyo Shinan Koho   1994-2007

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2001-131507 A  (Nitto Denko Corp.), 15 May, 2001 (15.05.01), Claims 1 to 4; Par. Nos. [0004] to [0035] & JP 2004-277749 A    & JP 2006-152308 A & EP 1097977 A2       & US 2003/0203193 A1 & CN 1295103 A         & KR 2001051480 A & KR 2005097908 A | 1-7 |
| X | JP 2001-323228 A  (Nitto Denko Corp.), 22 November, 2001 (22.11.01), Claims 1 to 5; Par. Nos. [0004] to [0026], [0031] to [0033] & EP 1156093 A2       & US 2001/0055678 A1 & CN 1323865 A | 1-7 |

☐ Further documents are listed in the continuation of Box C.      ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 13 November, 2007 (13.11.07) | 27 November, 2007 (27.11.07) |

| Name and mailing address of the ISA/ | Authorized officer |
|---|---|
| Japanese Patent Office | |
| Facsimile No. | Telephone No. |

Form PCT/ISA/210 (second sheet) (April 2007)

12

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP S5124534 B
- JP S5661468 A
- JP S5661469 A
- JP S60252681 A
- JP 2001131507 A
- JP 2002146299 A